# EUROPEAN PATENT SPECIFICATION

(11) **EP 1 690 289 B1**
(45) Date of publication and mention of the grant of the patent: **16.02.2011**
(21) Application number: 03789586.9
(22) Date of filing: 03.12.2003
(51) Int. Cl.: H01L 21/324, H01L 21/302, H01L 21/477

(54) **PROCESS FOR IMPROVING THE SURFACE ROUGHNESS OF A WAFER**
VERFAHREN ZUR VERBESSERUNG DER ÖBERFLÄCHENRAUHIGKEIT EINES HALBLEITERWAFERS
PROCEDE PERMETTANT DE REDUIRE LA RUGOSITE DE SURFACE D'UNE TRANCHE

(43) Date of publication of application: 16.08.2006
(73) Proprietor: S.O.I.Tec Silicon on Insulator Technologies, 38190 Bernin (FR)
(72) Inventor: NEYRET, Eric, 38360 SASSENAGE, (FR); ARENE, Emmanuel, F-38330 Biviers (FR); ECARNOT, Ludovic, 38450 VIF, (FR)
(74) Representative: Collin, Jérôme
(86) International application number: PCT/IB2003/006380
(87) International publication number: WO 2005/055308

(56) References cited:
- EP-A- 1 061 565
- EP-A- 1 193 739
- WO-A-03/005434
- FR-A- 2 827 423
- US-A- 5 904 491
- US-A1- 2003 030 147
- US-A1- 2003 203 657

## Description

The present invention generally relates to the surface treatments of materials, and particularly the treatment of wafers to be used for manufacturing components for applications in microelectronics and/or optoelectronics.

More precisely, the invention concerns a process for reducing the roughness of the free surface of a semiconductor wafer, said process comprising a single annealing step for smoothing said free surface, said single annealing step being carried out as a RTA under an atmosphere of pure argon.

The term "free surface" refers to a wafer surface which is exposed to the outer environment (thus differing from a surface defined by an inner interface between two layers of a multilayer wafer).

As it will be apparent from the description, the invention can advantageously be implemented in combination with a process for making thin layers, such as described in the patent FR 2 681 472 (though such combination is not limiting the scope of the invention).

A process reproducing the teachings of the above mentioned patent is known as the Smart-Cut^{®} process. Its main steps are schematically the following :
- Implantation of species under the surface of a semiconductor donor substrate - also called "top" and made e.g. in silicon or silicon-germanium, in an implantation region of the top,
- Contact of the implanted top with a receiving substrate - also called "base",
- Cleaving the implanted top at the implantation region, in order to transfer on the base the part of said top which is located between the implanted region and the implanted surface, and thus form a thin semiconductor layer on the base.

By "implantation of species" is meant an implantation of one or more atomic or ionic species so as to introduce such species in the material of the implanted wafer, with a maximum of the concentration of the species at a determined depth of the implanted wafer, and generate an enbrittlement zone.

The case where different species are implanted is generally referred to as "co-implantation".

The depth of the enbrittlement zone in the implanted wafer is a function of the nature of the implanted species, and the energy of implantation.

In this text, the generic term "wafer" shall refer to the structure comprising a layer transferred on a base substrate, as obtained by such a Smart-Cut^{®}-type process.

And in this text the term of "wafer" furthermore generally refers to any layer, substrate or wafer, whatever its origin (Smart-Cut^{®}-type process or not). Such "wafer" can also be a wafer of bulk material.

In all cases, the general objective of the invention is to improve the roughness of the free surface of the wafer.

This objective of improving the wafer can be achieved:
- By lowering the roughness of the surface (mean roughness), but also
- by increasing the homogeneity of the roughness over the surface.

For applications such as mentioned at the beginning of this text, the roughness specifications for the free surface of the wafer are indeed very severe, and the quality of the free surface of the wafer is a parameter which is critical for the quality of the components which shall be made on the wafer.

It is e.g. common to find roughness specifications of max. 5 Angströms rms.

It is specified that roughness measurements are generally made with an AFM microscope.

With such device, the roughness is measured on surfaces scanned by the tip of the AFM microscope, the size of such surfaces being possibly between e.g. 1x1 µm² and 10x10 µm², sometimes 50x50 µm² or even 100x100 µm².

Roughness can be characterized in particular according to two main methods.

According to a first main method, roughness is said to be "high frequency roughness" ; it corresponds to scanned surfaces of about 1x1 µm².

According to the other main method, roughness is said to be "low frequency roughness"; it corresponds to scanned surfaces of about 10x10 µm² or more. The specification of 5 Angströms given above as an illustration is a roughness which typically corresponds to a scanned surface of 10x10 µm².

And wafers which are made by known processes (Smart-Cut^{®}-type process or other) present a free surface roughness which are higher than specification such as mentioned above, in the absent of a specific surface treatment such as a polishing operation.

According to a first known type of a surface treatment, the wafer undergoes a "classical" thermal treatment (e.g. sacrificial oxidation).

But such a surface treatment does not bring the roughness down to specifications as mentioned above.

It would of course be possible to multiply successive steps of classical thermal treatment and/or combining such treatments with other known surface treatments, in order to further reduce roughness.

But this would increase the time needed for such a treatment, and the complexity of the process.

A process as described in EP 1 061 565 is an illustration of such classical thermal treatment. This document discloses an annealing step carried out over a long period (about 60 minutes) with a high temperature.

This annealing is followed by a cooling under an atmosphere containing hydrogen.

According to a second known type of a surface treatment, a chemical - mechanical polishing (CMP) is applied to the free surface of the wafer.

This type of treatment can indeed reduce the roughness of the free surface of the wafer.

In the case where there is within the wafer a gradient of concentration of defaults increasing towards the surface, this second type of known surface treatment can furthermore allow the abrasion of the wafer down to a region associated to an acceptable default concentration.

But this second type of known surface treatment can possibly compromise the uniformity of the free surface of the wafer (in particular the uniformity of the thickness of the surface layer).

This drawback is furthermore increased if an important polishing is required, which would generally be the case in order to obtain low roughness values such as mentioned above.

According to a third known type of surface treatment, the wafer is exposed to a rapid thermal annealing (RTA), under a controlled atmosphere.

In this third type of known surface treatment, the wafer is annealed in a high temperature, e.g. in the order of 1100 to 1300° C, during a time which can run from about one second to a few tens of seconds.

According to a first variant of this third type of surface treatment, the free surface of the wafer is smoothed by a RTA of the wafer in an atmosphere made of a mixing generally containing hydrogen in combination with reactive gases (HCl, HF, HBr, SF6, CF4 NF3, CCl2F2, ..).

US 6 171 965 gives an example of such variant. EP 1 061 565 also discloses a RTA (carried out under an hydrogen atmosphere).

In this first variant of the third known surface treatment, the reactivity of the mixed annealing atmosphere allows etching of the free surface of the wafer, which reduces its roughness.

This first variant can be regarded as advantageous.

An embodiment disclosed by EP 1 061 565 corresponds to this first variant of the third known type of a surface treatment.

In this embodiment, a RTA is carried out in an atmosphere which systematically comprises hydrogen.

However, a limitation of such variant derives from the fact that the annealing atmosphere is reactive.

Elements other than the free surface of the wafer which is to be annealed can thus be exposed to the action of such atmosphere (such elements can be e.g. the surface of the wafer which is opposed to the surface to be treated, walls of the annealing chamber....).

It can thus be necessary to use additional means to protect such elements. This tends to further complexify the process.

And the reactivity of the mixed atmosphere can also possibly further degrade some defaults of the wafer, which of course is undesired.

Furthermore, such variant can necessitate a specific installation (for e.g. feed the annealing device with the different gases, and/or ensure security....). This constitutes a further constraint.

According to a second variant of the third known type of surface treatment, the wafer is exposed to a RTA under an atmosphere which does not attack the material of the wafer.

In such variant, the smoothing is not obtained by etching the free surface of the wafer, but rather by reconstructing it.

The annealing atmosphere is in this case typically composed of hydrogen mixed with argon or nitrogen.

EP 1 158 581 discloses such a surface treatment. The treatment disclosed by this patent systematically comprises two different annealing steps, one of them being a RTA. These annealing steps can be carried out in an atmosphere containing hydrogen or argon.

The two annealing steps disclosed by this patent aim at smoothing the free surface of a wafer. The decrease of low frequency roughness is illustrated by the last column of table 2 of this patent, which in particular shows the effect of a second annealing after the RTA.

Indeed, according to this patent a single RTA ("exemple comparatif 1") leads to a low frequency roughness of 1,60 nm rms. By having this RTA followed by a subsequent additional annealing step, low frequency roughness is brought down to values of 0,28 and 0.30 nm rms.

EP 1 158 581 thus teaches two successive annealings, the first annealing being a RTA.

But the fact that the process disclosed by EP 158 581 systematically comprises two distinct annealing steps makes such process relatively long and complex.

An object of the invention is to improve the known surface treatment processes, such as mentioned above.

It would indeed be advantageous to further simplify, speed and ease such known processes.

Furthermore, it would also be advantageous to reduce possible slip lines such as the ones that can appear in the crystallographic structure of the material of the wafer, in particular after a thermal treatment (such as the thermal treatment applied to the wafer to cleave it in a Smart-Cut^{®}-type process).

Such slip lines can be generated by local differences in the heat budget received by different regions of the surface of the wafer (this being even more the case with annealing devices presenting cold points).

In addition, the hydrogen used in this variant is a volatile gas, which leads to the fact that significant amounts of hydrogen can be used - while it is constantly sought to diminish the cost associated to the surface treatment of wafers.

Finally, it would be particularly advantageous to implement a process fulfilling the above mentioned objectives, in combination with a Smart-Cut^{®}-type process.

WO 03/005434 brings an advantageous solution in order to meet the objectives mentioned above.

This document disposes a heat treatment which is a single annealing, carried out as a RTA under a pure argon atmosphere.

Such treatment reveals advantageous, as it improves surface roughness without being exposed to the drawbacks mentioned above in reference to other techniques.

The goal of the invention is to further improve this last treatment. Indeed, if such treatment greatly reduces the mean value of the surface roughness of the treated wafer, some inhomogeneities still remain in the distribution of roughness over the surface of the wafer.

A further goal of the invention is thus to improve roughness homogeneity over the wafer surface.

It is indeed reminded that in the perspective of the surface treatment of the wafer the objective is to not only to reduce the mean value of the surface roughness of the wafer.

Indeed, it is also sought to obtain a roughness distribution which is as homogeneous as possible over the surface of the wafer.

In particular, it is desired to avoid obtaining a treated surface which present different regions corresponding to different values of roughness.

To reach the goals mentioned above, the invention proposes a process according to claim 1.

Preferred, but non-limiting aspects of such process are defined by the dependent claims.

Other aspects of the invention shall be apparent from the following description, made in reference to the drawings on which :
- Figure 1 is a general and schematical representation in longitudinal cut of an annealing chamber which can be used in the invention,
- Figure 2 is a graph illustrating the decrease of roughness obtained by a RTA carried out for the invention, on a silicon wafer,
- Figure 3 is a graph illustrating the evolution of temperature for a RTA carried out under an atmosphere of pure argon,
- Figure 4 is a graph illustrating the evolution of temperature for a thermal treatment according to an embodiment of the invention,
- Figures 5a and 5b illustrate the roughness distribution aver two respective wafers, the wafer of figure 5a having undergone a pure argon RTA without preliminary treatment, the wafer of figure 5b having furthermore undergone a preliminary treatment before the pure argon RTA.

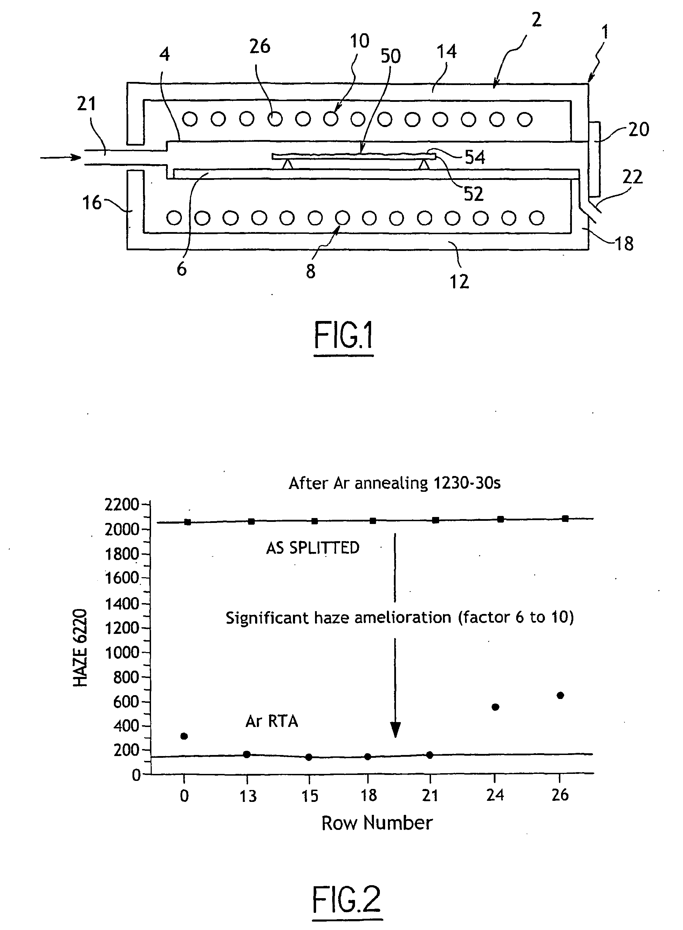

Figure 1 schematically shows a non-limiting example of an annealing chamber 1 which can be used for implementing the invention.

This chamber is to be used for a RTA thermal treatment, carried out under a 100% pure Argon atmosphere.

The chamber 1 comprises an inner space delimited by walls 2. It further comprises a reactor 4, a carrier 6 for carrying a wafer to be annealed, two networks 8, 10 of halogen lamps and two pairs of lateral lamps (not represented).

The walls 2 comprise in particular a lower wall 12, an upper wall 14 and two lateral walls 16, 18 located at the opposite longitudinal ends of the inner space.

One of the two lateral walls 16 comprises a door 20 for introducing/retrieving the wafer into/from the reactor.

Reactor 4 is made of a quartz tube which extends longitudinally between the lateral walls 16, 18. It is provided at each of these lateral walls 16, 18 respectively with a gas inlet 21 and a gas outlet 22. The gas outlet 22 is located on the side of the lateral wall 18 which comprises the door 20.

Each network of halogen lamps 8, 10 is located respectively above and under reactor 4, between said reactor and the lower and upper walls 12 and 14.

Each network of halogen lamps 8, 10 comprises in this embodiment seventeen lamps 26 collectively disposed orthogonally to the longitudinal axis of reactor 4.

The two pairs of lateral lamps (not represented on Figure 1) are disposed parallel to the longitudinal axis of reactor 4, each lamp being on one side of said reactor. Each of these lateral lamps is located near the longitudinal end of networks 8, 10.

The carrier 6 supports a wafer 50 which is to undergo a RTA under a pure Argon atmosphere. This carrier can slide into reactor 4, thus allowing introduction and extraction of the wafer into and from the reactor.

It is thus understood that the RTA of the invention is a single wafer heat treatment, the wafers being treated one at a time.

Non-limiting examples of devices which can be used as an annealing chamber of this type are e.g. the device "SHS AST 2800" sold by STEAG^{®}, or "Radiance^{®} devices from Applied Materials.

It is reminded that the wafer 50 can be any type of wafer, be it monolayer or multilayer, comprising at least a surface layer in a semiconductor material (such as e.g. silicon or silicon-germanium).

The invention can be used for improving the surface roughness of wafers 50 of any origin

In particular, the invention applies to improving the surface roughness of wafers of the SOI (Silicon On, Insulator) or SGOI (Silicon-Germanium On Insulator) type.

And the treated wafers can have been obtained e.g. by a Smart-Cut^{®}-type process.

Indeed, in combination with such a Smart-Cut^{®}-type process the invention can be used for improving the surface roughness of one or the other (or both) free surfaces generated by the cleaving step at the embrittlement zone.

Furthermore, the implantation of such Smart-Cut^{®}-type process can have been done by co-implantation of two (or more) different species. An example of such co-implantation in combination with a Smart-Cut^{®}-type process is given in the application FR 03 09304 in the name of the applicant.

And the different embodiments of the invention can be applied to a wafer 50 comprising a working surface layer 52 made in semiconductor material (e.g. silicon or silicon-germanium), said layer having a free surface 54.

Layer 52 is referred to as a "working" layer because it shall then be used for making electronic, optic or opto-electronic components on the wafer 50.

As mentioned above, surface 54 can have been generated by the cleaving step of a Smart-Cut^{®}-type process.

In such case, the wafer 50 comprises under the working layer 52 a buried oxide layer, which itself covers a support substrate.

On Figure 1, the thickness of wafer 50 has been exaggerated in order to show layer 52.

As mentioned above, the invention implies a single heat treatment of wafer 50 comprising a RTA carried out in a pure Argon atmosphere.

Such RTA comprises the following general operations :
- Introducing wafer 50 in the chamber 1, said chamber being "cold" (i.e. less than 400°C) at this time,
- Establishing in the chamber, at a pressure which is equal or close to the atmospheric pressure, an annealing atmosphere of pure Argon. The pressure can also be set to a lower value, from a few mTorr to the atmospheric pressure,
- Increasing the temperature in the chamber at a rate of about 50°C/s by selectively powering the halogen lamps 26, up to a RTA temperature,
- Maintaining wafer 50 in the chamber at a constant temperature, during a RTA duration (from about one second to a few tens of seconds),
- Shutting off lamps 26 and cooling, by air circulation, the wafer 50, at a rate of several tens of °C per second, and according to any desired cooling law.

In this respect, it is particularly important that the argon used be the purest possible since the applicant has determined that the presence (even in low quantities) of other elements (such as in particular oxygen) in the annealing atmosphere could generate an attack of the material of the working layer during the RTA.

"Pure" argon is thus understood in this text as argon containing less than 1 ppm of other elements (pollutants, other gases, ...).

For that purpose, the argon used must be treated in order to be purified before its introduction within the annealing chamber. Commercially available argon indeed does not present the high degree of purity which is required for the invention.

The purifying treatment can be carried out by purifiers and/or filters on the alimentation line which brings argon into the chamber.

An "attack" as mentioned above can correspond e.g. to a formation of SiO (which is very volatile) in the case of a Si working layer exposed to an annealing atmosphere containing a low quantity of oxygen.

The applicant has determined that such single heat treatment under the form of a RTA made in a pure Argon atmosphere significantly improved surface roughness of the wafer.

In particular, such RTA improves roughness much better than what would be obtained by a known thermal treatment such as sacrificial oxidation.

And furthermore, the uniformity of the working layer is much better than with a CMP treatment.

The RTA can comprise a constant temperature level having a duration of 1-30 s, at a temperature of e.g. 1100 to 1250°C.

Figure 2 illustrates the mean roughness diminution obtained by such RTA.

On this figure, the horizontal axis described different wafers, the haze of each wafer having been measured before such RTA (dots in the higher part of the graph), and after such RTA (dots in the lower part of the graph).

On figure 2 the higher curve thus corresponds to a haze measured on the surface of SOI wafers as splitted (immediately after cleaving), and the lower curve to the same kind of measure, after the same wafers have undergo a RTA under pure Argon with a 30s constant temperature at 1230°C.

It is specified that the term "haze" refers to an optical signal diffused by the light of wafer 50, in response to an excitation light. This haze is representative of the surface roughness.

In the case of Figure 2, this haze is measured using a KLA Tencor^{®} Surfscan 6220^{®} : the haze is thus here referred to as "haze 6220".

The observed diminution of haze is at least comparable to the results that could be obtained by other RTA techniques, e.g. RTA under an atmosphere comprising hydrogen mixed with argon.

More precisely, the haze is divided by a factor 6 to 10.

And in the case of the RTA of the invention, such advantageous results are obtained without the drawbacks exposed in introduction of this text, in reference to these known RTAs.

It should also be noted that argon has excellent thermal conductivity properties.

This tends to favour an homogeneous repartition of heat in the annealing chamber, and consequently :
- A more homogenous roughness distribution, and
- a diminution of the risk of slip lines.

The specific RTA used in the invention allows a very good smoothing of the free surface of the wafer. It should be noted that such smoothing is obtained with practically no erosion of material of the wafer 50, but rather by a reconstruction of the surface.

The invention furthermore implies a preliminary treatment of the wafer surface before the specific RTA described above.

The applicant has indeed observed that if such specific RTA (as generally disclosed in WO 03/005434) was very advantageous, it was still possible to further improve the surface roughness of the wafer in terms of roughness homogeneity.

In the absence of such preliminary treatment, it could indeed be possible to obtain a wafer surface with some regions having a slightly higher roughness than other regions (such "rougher" regions being typically located in the centre of the surface of the wafer).

Such possible variations in surface roughness are due to the presence of pollutants on the surface of the wafer, before carry outing the pure argon RTA.

Indeed, it is reminded that the RTA annealing of the invention is a wafer-by-wafer annealing.

In an industrial exploitation of such annealing, successive wafers will undergo the RTA in the same chamber, one after the other.

Therefore, when a wafer is introduced within the chamber to undergo RTA, it is desirable that the atmosphere of the chamber be as free as possible of elements (such as residual gases) produced by the opening of the chamber door when introducing the next wafer to be treated..

The atmosphere of the chamber after opening the chamber door can indeed contain gases such as 02, CO2, etc.. as well as H2O vapour. Such remaining gases are undesirable in the chamber for the next RTA to be carried out.

After opening the chamber and closing it again after introduction of the wafer to be treated, it is thus necessary to purge the atmosphere of the chamber before carry outing the next RTA on another wafer.

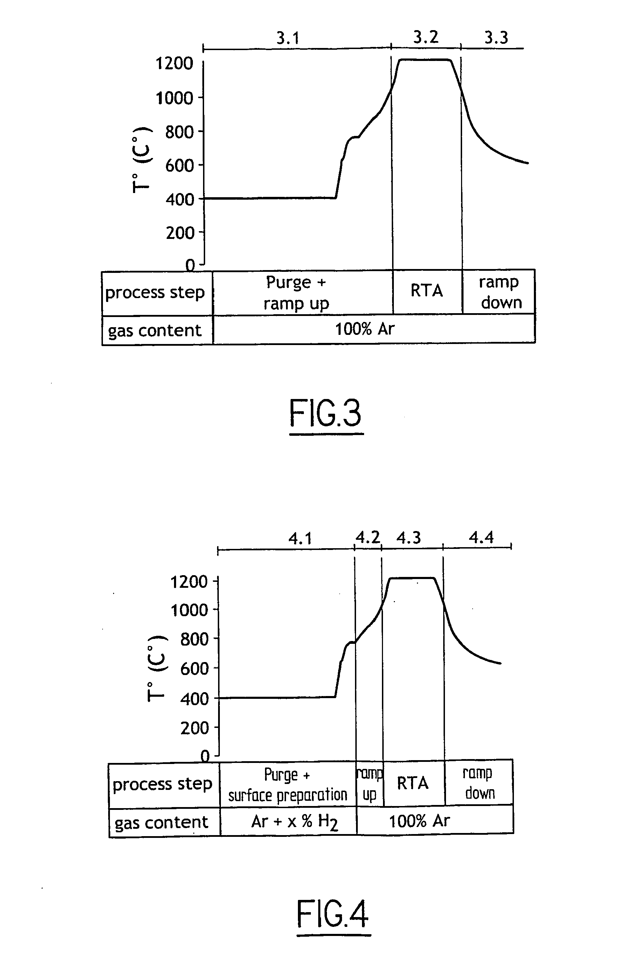

Figure 3 globally illustrates a single annealing carried out as a pure argon RTA (this constituting a base for the improvement proposed by the invention).

This annealing comprises an initial phase 3.1 of the heat treatment which corresponds to a purge of the atmosphere of the chamber, and to the ramp-up in temperature from the "cold" temperature of the chamber (i.e. less than 400°C - it is indeed specified that the temperature sensor used for building the graphs of Figures 3 and 4 indicates a fixed value of 400°C for temperatures which are in fact less than 400°C, and the actual value of temperature only for temperatures which are more than 400°C).

The initial phase 3.1 is followed by :
- A RTA during 1 to 30 s (phase 3.2), at 1150-1230°C,
- A cooling (phase 3.3).

In the initial phase 3.1, the ramp-up is carried out with two main steps :
- A first step up from 400°C to a pre-stabilisation temperature of about 750°C,
- A second step from the pre-stabilisation temperature to the RTA temperature (between 1150 and 1230 °C).

During this initial phase, a purge of the atmosphere of the chamber has been carried out, in order to evacuate undesirable gases.

This purge is a classical purge, with an evacuation of the atmosphere introduced within the chamber together with the wafer, and the establishment of a pure argon atmosphere.

The table at the bottom part of figures 3 and 4 indicates the process step, as well as the gas composition within the annealing chamber.

In the case of figure 3, the atmosphere is thus composed of pure argon during the whole process.

And the initial purge has allowed to evacuate from the annealing atmosphere pollutants which could generate variations in surface roughness after the pure argon RTA.

The applicant has however determined that the pollutants which can generate variations in surface roughness after the pure argon RTA can be not only elements present in the initial atmosphere in the annealing chamber, but also elements present on the wafer surface even before introducing the wafer in the annealing chamber.

Indeed, the applicant has observed that even with an initial purge of the annealing chamber before a pure argon RTA, some variations in roughness are still to be observed on the treated wafers.

For the purpose of clarity, such elements present on the wafer surface and which could generate variations in surface roughness after the pure argon RTA shall herein be referred to as "preliminary pollutants".

Such preliminary pollutants can be in particular a native oxide on the wafer surface, or other pollutants such as hydrocarbons.

The invention therefore provides a preliminary treatment before the pure argon RTA in order to eliminate the undesirable effects associated to the preliminary pollutants, and improve surface roughness even more than with a pure argon RTA (in particular in terms of homogeneity)

A main embodiment and a preffered variant of such preliminary treatment are proposed.

Each corresponds to a single annealing, carried out as a pure argon RTA, and proposes preliminary treatments to be carried out in association with such single annealing.

According to a main embodiment of the preliminary treatment, the initial purge of the annealing chamber is combined with a controlled enrichment of the atmosphere within the annealing chamber.

This embodiment is illustrated on Figure 4.

In this main embodiment, during the initial phase of the annealing (phase 4.1 on Figure 4), the chamber is not only purged, but also filled with a controlled atmosphere comprising argon and a controlled proportion of a secondary gas.

The secondary gas is hydrogen, HCl, or a mixture of both.

On figure 4, the secondary gas is hydrogen (see table below the graph).

The "controlled proportion" is generally between 0.5 and 30 %.

More precisely, if the secondary gas is hydrogen, the "controlled proportion" should be between 0.5 and 30 %.

If the secondary gas is HCl, the "controlled proportion" should be between 0.5 and 5 %.

If the secondary gas is a mixture of hydrogen and HCl, the "controlled proportion" should be between 0.5 % and a percentage between 5 and 30 %, depending on the ratio (hydrogen/HCl) in the secondary gas.

It is to be noted that with the injection of a secondary gas, the "initial" phase 4.1 is limited in time to the purge and the initial raise in temperature - up to the pre-stabilisation temperature of about 750°C (this temperature being too low for a smoothing to occur).

This initial phase 4.1 allows to eliminate (or at least drastically reduce) the preliminary pollutants.

In this embodiment, the preliminary treatment is carried out in the same general operation that the RTA itself.

It should however be noted that this initial phase 4.1 does not correspond to a pre-anneal, since the temperature is very low (less than 400°C - and sometimes even significantly less, since this initial phase can be carried out at temperatures which can typically be between 100 and 400°C). Phase 4.1 is a controlled purge phase.

Once this pre-stabilisation temperature has been reached, the atmosphere of the chamber is changed so as to eliminate all secondary gas, and have a pure argon atmosphere for the ramp-up to the RTA temperature (phase 4.2), and the RTA itself (phase 4.3).

The RTA is essentially the same as the one described above in reference to figure 3 (phase 3.2).

Finally, a cooling phase 4.4 ends the process. It is similar to phase 3.3 mentioned in reference to figure 3.

In this embodiment, the secondary gas injected in the initial phase 4.1 favors the elimination of the preliminary pollutants (in particular native oxide) from the wafer surface, during the initial phase 4.1.

A wafer having undergone such preliminary treatment can then be subject to a pure argon RTA : not only will the roughness of the wafer surface be significantly reduced, but furthermore this roughness will be homogeneous over the wafer surface.

This is illustrated by the following table, which shows surface roughness after the pure argon RTA for two SOI wafers (wafer 1 and wafer 2), and for three modes of roughness measurements - from a scanned surface of 2x2 µm² to a scanned surface of 40x40 µm².

| | ***AFM roughness (Angström rms)*** | | |
|---|---|---|---|
| | 2x2 µm² | 10x10 µm² | 40x40 µm² |
| Wafer 1 : | 1.5 | 5 | 7 |
| Standard roughness region | | | |
| Wafer 1 : | 6.2 | 11.7 | 13.7 |
| High roughness region (no preliminary treatment) | | | |
| Wafer 2 : | 1.5 | 5 | 7 |
| Whole wafer surface | | | |

In this table, wafer 1 has not undergone any preliminary treatment before the pure argon RTA.

The surface of this wafer 1 exhibits two different regions :
- A "Standard roughness region" with a surface roughness kept at a low level,
- A "High roughness region" with a substantially higher roughness..

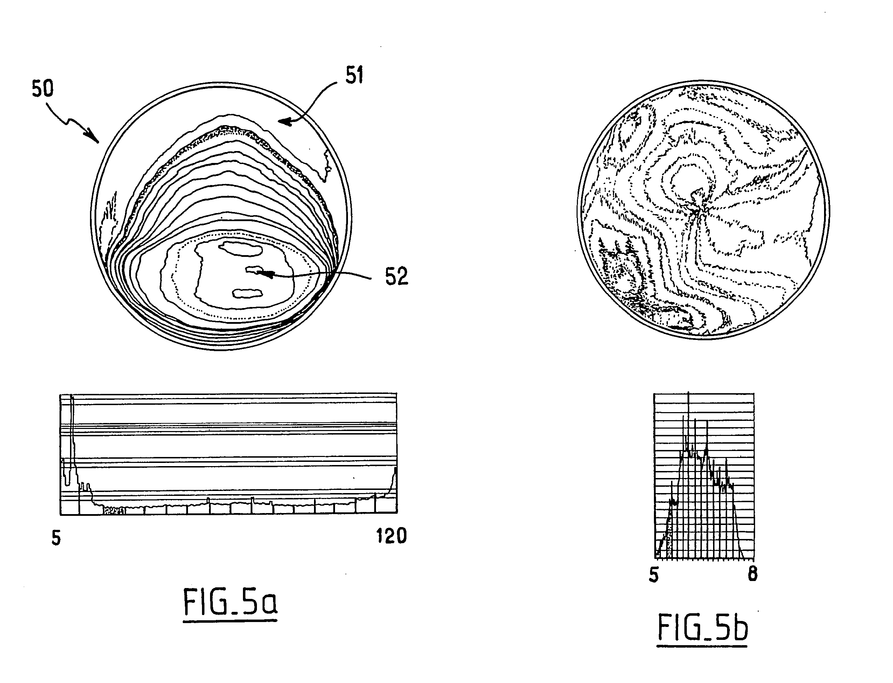

Figure 5a illustrates the roughness distribution over the surface of a wafer after a pure argon RTA. The upper part of the figure shows the haze repartition over the wafer surface.

The wafer 50 illustrated in figure 5a is representative of the "wafer 1" mentioned above, as it has not undergone any preliminary treatment before the pure argon RTA.

In the lower part of figure 5a, an histogram summarizes the distribution of haze values (directly related to roughness values).

This figure shows that the roughness values are widely distributed (from 5 to 120 ppm - see histogram).

And the upper part of the figure exhibits a higher roughness region 52, located in the lower central part of the wafer, The region 51 is on the contrary a lower roughness region.

The wafer illustrated on figure 5a is thus associated to :a wide distribution of roughness, and to marked higher roughness regions.

Wafer 2 of the above table has undergone a preliminary treatment (according to the embodiment described above).

This wafer is illustrated on figure 5b, which is a representation similar to the representation of figure 5a for wafer 1.

It can be seen that this wafer 2 does not exhibit any "High roughness region" - after the pure argon RTA the low surface roughness is indeed evenly distributed on the wafer (see in particular the histogram in the lower part of figure 5b).

The preliminary treatment is thus advantageous as it significantly enhances roughness homogeneity.

It is furthermore convenient, because it takes advantage of the necessary purge phase before the RTA. No additional step is thus required.

According to a preferred variant of the main embodiment of the preliminary treatment, prior to the pure argon RTA the wafer is subjected to a preliminary treatment carried out under the form of a chemical cleaning of the wafer surface.

Here again, the wafer can be in particular (though this is non limiting of the scope of the invention) a SOI or SGOI wafer. And it can have been obtained by a Smart-Cut^{®}-type process.

The cleaning is carried out immediately before introducing the wafer in the annealing chamber.

This cleaning allows the elimination of the preliminary pollutants. This improves the roughness observed after the pure argon RTA - in particular in terms of homogeneity.

The cleaning is preferably a RCA cleaning, or a HF cleaning.

A RCA cleaning comprises two successive chemical bathes.

A first bath is made into a SC1 solution (aqueous solution of NH4OH and H2O2).

The applicant has found that the concentration of both NH4OH and H2O2 must be between 1 % and 5 % (molecular weight).

More precisely, for the preliminary treatment of a wafer having a silicon surface layer (e.g. a SOI), preferred concentrations are 1% for NH4OH and 2% for H2O2.

A second bath is then made into a solution of SC2 (aqueous solution of HCl and H2O2).

The applicant has found that the concentration of both HCl and H2O2 must be between 0.1 % and 5 % (molecular weight).

More precisely, for the preliminary treatment of a wafer having a silicon surface layer (e.g. a SOI), preferred concentrations are 1% for HCl and 1% for H2O2.

The temperature for the SC1 and SC2 bath should preferably between 20 and 80°C, more preferably 70°C for a wafer having a silicon surface layer.

A HF cleaning shall in particular etch the native oxide SiO2 than can be present on the wafer surface.

The applicant has found that the concentration of HF must be between 0.1 % and 49 % (molecular weight). A HF concentration which is well-adapted is 20%.

The HF bath should preferably be carried out at room temperature (about 20°C). In both cases (RCA and HF cleaning), the cleaning can be combined with rinsing steps. However, in the case of a HF cleaning, no rinsing should preferably be done after the cleaning,

As mentioned above, in this preferred variant of the main embodiment also the wafer to be treated can be in particular a SOI or SGOI wafer.

It is to be noted that in the case of a wafer having a surfaces layer in SiGe, the concentration of Ge in said layer should preferably be no more than 20%.

Moreover, generally speaking (be it for the RCA or HF cleaning, or for the other possible types of chemical cleaning), the parameters of the preliminary treatment under the form of a chemical cleaning shall be set so as to have a less aggressive cleaning for a SGOI wafer than for a SOI wafer.

Such adaptation of the cleaning for a SGOI wafer is obtained in particular by:
- Adopting cleaning agents which are more diluted, and/or
- Setting the temperature to a lower value for the cleaning.

Embodiments described above allow to further improve the general process disclosed in WO 03/005434.

In particular, the surface roughness of a wafer treated by one of these embodiments is:
- Even further reduced, and
- More evenly distributed (in particular, no higher roughness region is observed In the central region of the wafer).

## Claims

1. Process for reducing the roughness of the free surface of a semiconductor wafer, said process comprising a single annealing step for smoothing said free surface, said single annealing step being carried out in an annealing chamber as a RTA under an atmosphere of pure argon containing less than 1 ppm of other elements, **characterized in that** before the RTA the atmosphere of the annealing chamber is purged and filled with a controlled atmosphere allowing reduction of preliminary pollutants present on the wafer surfaces, said controlled atmosphere being composed of argon mixed with at least a secondary gas comprising hydrogen and/or HCl.

2. Process according to the preceding claim, **characterized in that** during said purge the temperature remains below 750 °C.

3. Process according to the preceding claim, **characterized in that** during said purge the temperature remains below 400 °C.

4. Process according to any preceding claim, **characterized in that** the secondary gas is hydrogen and is introduced in a controlled proportion which is between 0.5 and 30 %.

5. Process according to any preceding claim, **characterized in that** the secondary gas is HCl and is introduced in a controlled proportion which is between 0.5 and 5 %.

6. Process according to any preceding claim, **characterized in that** between the purge and the RTA the process comprises a temperature ramp-up from a pre-stabilisation temperature to the RTA temperature, said ramp-up being carried out in a pure argon atmosphere.

7. Process according to the preceding claim, **characterized in that** said pre- stabilisation temperature has a value of about 750 °C.

8. Process according to any preceding claim, **characterized in that** before the RTA a chemical cleaning of the wafer surface is carried out so as to further reduce the amount of preliminary pollutants on the wafer.

9. Process according to any preceding claim, **characterized in that** said RTA in a pure argon atmosphere is carried out at a temperature of 1150 to 1230 °C.

10. Process according to any preceding claim, **characterized in that** said RTA in a pure argon atmosphere is carried out during one to 30 seconds.

11. Process according to any preceding claim, **characterized in that** it is carried out on a wafer obtained by a Smart-Cut^{®}-type process.

12. process according to any preceding claim, **characterized in that** it is carried out on a SOI or SGOI wafer.

## Patentansprüche

1. Verfahren zur Verringerung der Rauhigkeit der freien Oberfläche eines Halbleiterwafers, wobei das Verfahren einen einzigen Temperschritt zum Glätten der freien Oberfläche umfasst und wobei dieser einzige Temperschritt in einer Temperkammer als RTA (schnelles thermales Tempern) in einer Atmosphäre aus reinem Argon, das weniger als 1 ppm anderer Elemente enthält, ausgeführt wird, **dadurch gekennzeichnet, dass** vor dem RTA die Atmosphäre der Temperkammer entleert und diese mit einer kontrollierten Atmosphäre gefüllt wird, die die Reduktion anfänglicher Verunreinigungen gestattet, die sich auf der Waferoberfläche befinden, wobei die kontrollierte Atmosphäre aus Argon gemischt mit wenigstens einem sekundären Gas, das Wasserstoff und/oder HCL umfasst, zusammengesetzt ist.

2. Verfahren nach dem vorhergehenden Anspruch, **dadurch gekennzeichnet, dass** während des Entleerens die Temperatur unter 750°C bleibt.

3. Verfahren nach dem vorhergehenden Anspruch, **dadurch gekennzeichnet, dass** während des Entleerens die Temperatur unter 400°C bleibt.

4. Verfahren nach einem der vorhergehenden Ansprüche, **dadurch gekennzeichnet, dass** das sekundäre Gas Wasserstoff ist und dass es in einem kontrollierten Verhältnis zugegeben wird, das zwischen 0,5 und 30% liegt.

5. Verfahren nach einem der vorhergehenden Ansprüche, **dadurch gekennzeichnet, dass** das sekundäre Gas HCl ist und dass es in einem kontrollierten Verhältnis zugegeben wird, das zwischen 0,5 und 5% liegt.

6. Verfahren nach einem der vorhergehenden Ansprüche, **dadurch gekennzeichnet, dass** zwischen dem Entleeren und dem RTA das Verfahren ein Hochfahren der Temperatur von einer Vorstabilisierungstemperatur auf die RTA-Temperatur umfasst, wobei das Hochfahren in einer reinen Argon-Atmosphäre ausgeführt wird.

7. Verfahren nach dem vorhergehenden Anspruch, **dadurch gekennzeichnet, dass** die Vorstabilisierungstemperatur einen Wert von etwa 750°C hat.

8. Verfahren nach einem der vorhergehenden Ansprüche, **dadurch gekennzeichnet, dass** vor dem RTA eine chemische Reinigung der Waferoberfläche ausgeführt wird, um die Menge an anfänglichen Verunreinigungen auf dem Wafer weiter zu verringern.

9. Verfahren nach einem der vorhergehenden Ansprüche, **dadurch gekennzeichnet, dass** das RTA in reiner Argon-Atmosphäre bei einer Temperatur von 1150 bis 1230°C ausgeführt wird.

10. Verfahren nach einem der vorhergehenden Ansprüche, **dadurch gekennzeichnet, dass** das RTA in reiner Argon-Atmosphäre für eine bis 30 Sekunden ausgeführt wird.

11. Verfahren nach einem der vorhergehenden Ansprüche, **dadurch gekennzeichnet, dass** es auf einem Wafer ausgeführt wird, der durch ein Verfahren vom Smart-Cut^{®}-Typ hergestellt wurde.

12. Verfahren nach einem der vorhergehenden Ansprüche, **dadurch gekennzeichnet, dass** es auf einem SOI- oder SGOI-Wafer ausgeführt wird.

## Revendications

1. Processus de réduction de la rugosité de la surface libre d'une tranche de semi-conducteur, ledit processus comprenant une seule étape de recuit pour lisser ladite surface libre, ladite seule étape de recuit étant effectuée dans une chambre de recuit comme un recuit thermique rapide dans une atmosphère d'argon pur contenant moins de 1 ppm d'autres éléments, **caractérisé en ce que**, avant le recuit thermique rapide, l'atmosphère de la chambre de recuit est purgée et remplie avec une atmosphère contrôlée permettant la réduction de polluants préliminaires présents à la surface de la tranche, ladite atmosphère contrôlée étant composée d'argon mélangé avec au moins un gaz secondaire comprenant de l'hydrogène et/ou du HCl.

2. Processus selon la revendication précédente, **caractérisé en ce que**, pendant ladite purge, la température reste inférieure à 750°C.

3. Processus selon la revendication précédente, **caractérisé en ce que**, pendant ladite purge, la température reste inférieure à 400°C.

4. Processus selon l'une quelconque des revendications précédentes, **caractérisé en ce que** le gaz secondaire est de l'hydrogène et est introduit dans une proportion contrôlée qui se situe entre 0,5 et 30 %.

5. Processus selon l'une quelconque des revendications précédentes, **caractérisé en ce que** le gaz secondaire est du HCl et est introduit dans une proportion contrôlée qui se situe entre 0,5 et 5 %.

6. Processus selon l'une quelconque des revendications précédentes, **caractérisé en ce que**, entre la purge et le recuit thermique rapide, le processus comprend une augmentation de la température afin de passer d'une température de pré-stabilisation à la température de recuit thermique rapide, ladite augmentation étant effectuée dans une atmosphère d'argon pur.

7. Processus selon la revendication précédente, **caractérisé en ce que** ladite température de pré-stabilisation possède une valeur d'environ 750°C.

8. Processus selon l'une quelconque des revendications précédentes, **caractérisé en ce que**, avant le recuit thermique rapide, un nettoyage chimique de la surface de la tranche est effectué de façon à réduire à nouveau la quantité de polluants préliminaires sur la tranche.

9. Processus selon l'une quelconque des revendications précédentes, **caractérisé en ce que** ledit recuit thermique rapide dans une atmosphère d'argon pur est effectué à une température de 1150 à 1230 °C.

10. Processus selon l'une quelconque des revendications précédentes, **caractérisé en ce que** ledit recuit thermique rapide dans une atmosphère d'argon pur est effectué pendant une à 30 secondes.

11. Processus selon l'une quelconque des revendications précédentes, **caractérisé en ce qu'**il est effectué sur une tranche obtenue par un processus de type Smart-Cut^{®}.

12. Processus selon l'une quelconque des revendications précédentes, **caractérisé en ce qu'**il est effectué sur une tranche SOI ou SGOI.
